# EUROPÄISCHE PATENTSCHRIFT

(11) **EP 2 997 660 B1**
(45) Veröffentlichungstag und Bekanntmachung des Hinweises auf die Patenterteilung: **24.06.2020**
(21) Anmeldenummer: 14725963.4
(22) Anmeldetag: 10.05.2014
(51) Int. Cl.: H03K 17/96

(54) **BERÜHRUNGS- UND/ODER ANNÄHERUNGSEMPFINDLICHES BETÄTIGUNGSELEMENT**
TOUCH AND/OR PROXIMITY-SENSITIVE ACTUATION ELEMENT
ÉLÉMENT D'ACTIONNEMENT SENSIBLE AU CONTACT ET/OU À LA PROXIMITÉ

(30) Priorität: 18.05.2013 DE 102013008702
(43) Veröffentlichungstag der Anmeldung: 23.03.2016
(73) Patentinhaber: Diehl AKO Stiftung & Co. KG, 88239 Wangen (DE)
(72) Erfinder: FROMMELT, Thomas, 81243 München (DE); LYSZUS, Joachim, 88255 Baindt (DE); FUHGE, Bruno, 88147 Achberg (DE); STOHR, Ralph, 88299 Leutkirch (DE); MAIGLER, Andreas, 88339 Bad Waldsee (DE)
(74) Vertreter: Diehl Patentabteilung
(86) Internationale Anmeldenummer: PCT/EP2014/001260
(87) Internationale Veröffentlichungsnummer: WO 2014/187536

(56) Entgegenhaltungen:
- WO-A1-2010/115014
- DE-U1-202005 019 978

## Beschreibung

Die vorliegende Erfindung betrifft ein berührungs- und/oder annäherungsempfindliches Betätigungselement, insbesondere ein solches Betätigungselement nach dem kapazitiven Funktionsprinzip, insbesondere ein solches Dreh-Betätigungselement und insbesondere ein solches Betätigungselement für elektronische Haushaltsgeräte.

In vielen elektronischen Haushaltsgeräten, wie Herden, Kochfeldern, Mikrowellenöfen, Spülmaschinen, Waschmaschinen, Wäschetrocknern und dergleichen werden häufig berührungs- und/oder annäherungsempfindliche Betätigungselemente bzw. Tastschalter eingesetzt, welche durch ein einfaches Berühren oder bloßes Annähern durch einen Benutzer(finger) zum Beispiel einen bestimmten Schaltvorgang auslösen und/oder eine Geräteeinstellung ändern können.

In diesem Zusammenhang sind insbesondere berührungs- und/oder annäherungsempfindliche Betätigungselemente bekannt, welche nach einem kapazitiven, induktiven, optischen, thermischen und/oder piezoelektrischen Funktionsprinzip arbeiten. Im Fall eines kapazitiven Betätigungselements bildet ein Sensorelement aus einem elektrisch leitfähigen Material zusammen mit zum Beispiel einem Finger eines Benutzers über eine als Dielektrikum wirkende Abdeckplatte aus einem elektrisch isolierenden Material eine Kapazität, die entsprechend dem Betätigen des Betätigungselements, d.h. dem Berühren oder Nicht-Berühren bzw. dem Annähern oder Nicht-Annähern, eines dem Sensorelement zugeordneten Erfassungsbereiches der Abdeckplatte variabel ist. Eine Veränderung dieses Kapazitätswertes des Sensorelements wirkt sich entsprechend auf ein Ausgangssignal der zugehörigen Sensorschaltung aus, welches von einer Auswerte/Steuerelektronik verarbeitet und ausgewertet werden kann, um ggf. eine Betätigung des kapazitiven Betätigungselements zu erfassen.

Neben einfachen Tastschaltern sind auch berührungs- und/oder annäherungsempfindliche Schieberegler bekannt. Eine Kombination aus berührungsempfindlichem Schieberegler und berührungsempfindlichen Tastschaltern ist zum Beispiel in der DE 20 2006 019 447 U1 offenbart.

Ferner offenbart die WO 2010/115014 A1 einen "virtuellen" Drehknopf, welcher lösbar auf der Benutzerseite einer Bedienblende sitzt und eine Fingerbewegung eines Benutzers entlang einer Kreisbahn führt. Diese Fingerbewegung eines Benutzers kann durch kapazitive Sensorelektroden erfasst werden, welche ringförmig auf einer Platine auf der dem Benutzer abgewandten Seite der Bedienblende angeordnet sind.

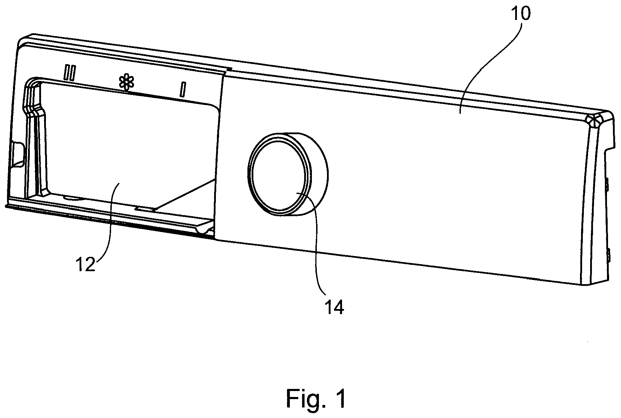

Außerdem offenbart die US 2010/0253653 A1 verschiedene Ausführungsvarianten eines "virtuellen" Drehknopfes, der orts- und drehfest an einer Bedienblende angeordnet ist. In einer Ausführungsvariante (Fig. 1A und 1B) ist der Betätigungsknopf auf eine dem Benutzer zugewandte Seite der Bedienblende geklebt und ist eine Leiterplatte mit ringförmig angeordneten Sensorelementen auf einer dem Benutzer abgewandten Seite der Bedienblende positioniert. In einer anderen Ausführungsvariante (Fig. 1F und 1G) ist der Betätigungsknopf integral mit der Bedienblende ausgebildet und ist die Leiterplatte mit den Sensorelementen entlang der Mantelfläche des Betätigungsknopfes in diesem angeordnet.

Es ist die Aufgabe der vorliegenden Erfindung, ein verbessertes berührungs- und/oder annäherungsempfindliches Betätigungselement in Form eines Drehknopfes zu schaffen.

Diese Aufgabe wird gelöst durch ein berührungs- und/oder annäherungsempfindliches Betätigungselement mit den Merkmalen des Anspruchs 1. Besonders bevorzugte Ausgestaltungen und Weiterbildungen der Erfindung sind Gegenstand der abhängigen Ansprüche.

Das berührungs- und/oder annäherungsempfindliche Betätigungselement der Erfindung weist auf: ein elektrisch nicht-leitfähiges Gehäuse, welches einen Befestigungsabschnitt zur orts- und drehfesten Montage des Betätigungselements an einer Bedienblende und einen im Wesentlichen zylindrischen Detektionsabschnitt, der einen berührungs- und/oder annäherungsempfindlichen Erfassungsbereich des Betätigungselements definiert, an dem eine rotatorische Bewegung eines Benutzers um das Betätigungselement erfassbar ist; mehrere elektrisch leitfähige Sensorelemente, welche entlang einer Mantelfläche des Detektionsabschnitts zueinander beabstandet in dem Gehäuse angeordnet sind; und eine Leiterplatte, welche mehrere Kontaktflächen aufweist, welche jeweils mit einem der mehreren Sensorelemente elektrisch leitend in Kontakt stehen. Die Leiterplatte ist auf einer dem Benutzer abgewandten Seite unmittelbar angrenzend an das Gehäuse angeordnet und das Gehäuse ist über den Befestigungsabschnitt drehfest an der Leiterplatte befestigt ist, wobei die mehreren Kontaktflächen im Wesentlichen entlang eines Ringes auf der Leiterplatte angeordnet sind und jeweils eines der mehreren Sensorelemente im Gehäuse elektrisch leitend kontaktieren.

Das erfindungsgemäße Betätigungselement stellt dem Benutzer einen Körper in der Form eines Drehknopfes zum Bedienen zum Beispiel eines elektronischen Haushaltsgerätes bereit. Dabei ist der Drehknopf selbst nicht bewegbar, insbesondere nicht drehbar; stattdessen wird eine rotatorische oder Drehbewegung zum Beispiel eines oder mehrerer Finger einer Benutzerhand - den Drehknopf berührend oder nicht - um diesen festen Drehknopf herum mittels der kapazitiven Sensorelemente in dem Gehäuse des Betätigungselements detektiert. Auf diese Weise wird ein "virtueller" Drehknopf geschaffen, der keine sich bewegenden / rotierenden Komponenten enthält und daher zuverlässiger, verschleißfreier und einfacher zu reinigen ist als herkömmliche Drehknöpfe.

Das erfindungsgemäße Betätigungselement weist neben den kapazitiven Sensorelementen auch eine Leiterplatte mit den zugehörigen Kontaktflächen auf. Auf diese Weise sind eine kompakte Konstruktion des Betätigungselements und eine einfache Montage als eine Baueinheit möglich.

Das Gehäuse ist vorzugsweise aus einem elektrisch nicht-leitfähigen Material, bevorzugt einem Kunststoffmaterial gefertigt. Das Gehäuse ist vorzugsweise als ein ein- oder mehrteiliges Spritzgussteil gefertigt. Der Befestigungsabschnitt und der Detektionsabschnitt des Gehäuses sind vorzugsweise einstückig miteinander ausgebildet oder fest miteinander verbunden.

Der Befestigungsabschnitt des Gehäuses dient der orts- und drehfesten Montage des Betätigungselements an einer Bedienblende zum Beispiel eines elektronischen Haushaltsgeräts. Die Montage ist dabei lösbar oder dauerhaft ausgestaltet. Die Montage des Befestigungsabschnitts erfolgt vorzugsweise mittels einer Klebeverbindung oder einer Schraubverbindung. Der Befestigungsabschnitt ist vorzugsweise in der Art eines Befestigungsflansches ausgebildet.

Der im Wesentlichen zylindrische Detektionsabschnitt hat in diesem Zusammenhang eine im Wesentlichen zylindrische Form mit einer Grundfläche und einer umlaufenden

Mantelfläche. Dabei ist die Grundfläche grundsätzlich beliebig geformt, vorzugsweise kreisförmig oder (bevorzugt regelmäßig) polygonal. Die Mantelfläche erstreckt sich über eine Höhe, welche wahlweise gleich groß, größer oder kleiner sein kann als die größte Ausdehnung (z.B. Diagonale) der Grundfläche. Die Mantelfläche verläuft ausgehend von der Grundfläche bevorzugt im Wesentlichen geradlinig oder ein- oder mehrfach, konvex oder konkav gekrümmt. Außerdem verläuft die Mantelfläche ausgehend von der Grundfläche bevorzugt im Wesentlichen senkrecht, sich konisch verjüngend oder sich konisch erweiternd. Ferner sind auch Kombinationen der hier genannten Gestaltungsformen der zylindrischen Form des Detektionsabschnitts denkbar.

In dem Gehäuse des Betätigungselements sind mehrere elektrisch leitfähige Sensorelemente angeordnet. Vorzugsweise sind zwei, drei, vier, sechs, acht, zwölf oder sechzehn Sensorelemente vorgesehen, ohne dass die Erfindung auf diese konkreten Zahlen beschränkt sein soll. Die mehreren Sensorelemente sind zueinander beabstandet, sodass sie elektrisch voneinander isoliert sind. Dabei ist zwischen den einzelnen Sensorelementen vorzugsweise jeweils ein Luftspalt oder eine Gehäusetrennwand angeordnet. Die mehreren Sensorelemente sind in dem Gehäuse angeordnet, sodass sie durch das Gehäuse gegenüber der Umgebung des Gehäuses bzw. des Betätigungselements elektrisch isoliert sind. Das Gehäuse kann auf diese Weise ein Dielektrikum einer durch ein Sensorelement und zum Beispiel einen Finger eines Benutzers gebildeten Kapazität bilden. Die mehreren Sensorelemente sind vorzugsweise im Wesentlichen gleich zueinander ausgebildet, es können aber auch unterschiedliche Arten, Formen und/oder Größen von Sensorelementen in einem Betätigungselement eingesetzt werden.

Die mehreren Sensorelemente sind dabei entlang der Mantelfläche des im Wesentlichen zylindrischen Detektionsabschnitts angeordnet. Die Sensorelemente erstrecken sich in diesem Zusammenhang jeweils wenigstens teilweise, vorzugsweise wenigstens 50% oder mehr über die Höhe des Detektionsabschnitts. Unter der Anordnung entlang der Mantelfläche ist in diesem Zusammenhang vorzugsweise eine Anordnung zu verstehen, bei welcher die (z.B. geometrischen) Schwerpunkte der Sensorelemente auf einer Linie liegen, welche im Wesentlichen parallel zur Mantelfläche verläuft. Dies bedeutet, dass die Sensorelemente selbst nicht notwendigerweise parallel zu dieser Mantelfläche verlaufen müssen, also zum Beispiel neben gekrümmten Platten insbesondere auch ebene Platten als Sensorelemente eingesetzt werden können. Außerdem sind die mehreren Sensorelemente vorzugsweise entlang der gesamten Mantelfläche des Detektionsabschnitts angeordnet, sie können aber wahlweise auch nur entlang eines Teilabschnitts der Mantelfläche vorgesehen sein.

Je mehr Sensorelemente vorgesehen sind und je größer der Abschnitt der Mantelfläche ist, entlang dem sie angeordnet sind, umso höher ist die erzielbare Genauigkeit bei der Erfassung einer rotatorischen Bewegung eines Benutzers um dieses Betätigungselement.

Die Leiterplatte weist mehrere Kontaktflächen auf. Vorzugsweise entspricht die Anzahl der Kontaktflächen der Anzahl der kapazitiven Sensorelemente. Vorzugsweise ist jedes der mehreren Sensorelemente mit genau einer dieser mehreren Kontaktflächen elektrisch leitend in Kontakt. Wahlweise kann auch ein Sensorelement mit zwei oder mehr Kontaktflächen elektrisch leitend in Kontakt stehen. Die Sensorelemente stehen dabei vorzugsweise unmittelbar oder mittelbar (d.h. über elektrisch leitende Kontaktelemente) mit den Kontaktflächen elektrisch leitend in Kontakt.

Die Leiterplatte ist Bestandteil des erfindungsgemäßen Betätigungselements. Die Leiterplatte ist dabei unmittelbar angrenzend an das Gehäuse angeordnet. Bevorzugt ist die Leiterplatte unmittelbar angrenzend an den Befestigungsabschnitt des Gehäuses angeordnet. Ferner ist die Leiterplatte vorzugsweise derart angeordnet, dass sie im montierten Zustand des Betätigungselements auf einer dem Benutzer abgewandten Seite zum Beispiel einer Bedienblende positioniert ist.

Das Funktionsprinzip eines berührungs- und/oder annäherungsempfindlichen kapazitiven Tastschalters ist dem Fachmann grundsätzlich bekannt. Der "virtuelle" Drehknopf der Erfindung setzt sich aus mehreren solchen berührungs- und/oder annäherungsempfindlichen Tastschaltern zusammen, welche entlang der Mantelfläche des im Wesentlichen zylindrischen Detektionsabschnitts angeordnet sind. Durch eine Erfassung und Auswertung der zeitlichen Veränderungen der Kapazitätswerte von mehreren, vorzugsweise von allen diesen Tastschaltern lassen sich sowohl ein Maß als auch eine Richtung einer Bewegung über mehrere Tastschalter hinweg ermitteln, im vorliegenden Fall somit Drehwinkel und/oder Drehrichtung der rotatorischen Bewegung des Benutzers.

Gemäß der Erfindung ist das Gehäuse über seinen Befestigungsabschnitt drehfest an der Leiterplatte befestigt und sind die mehreren Kontaktflächen im Wesentlichen entlang eines Ringes auf der Leiterplatte angeordnet, wobei sie jeweils (wenigstens) eines der mehreren Sensorelemente im Gehäuse elektrisch leitend kontaktieren. Die (lösbare oder dauerhafte) Befestigung des Gehäuses an der Leiterplatte ermöglicht einen kompakten Aufbau des gesamten Betätigungselements. Außerdem kann auf diese Weise eine Baueinheit geschaffen werden, die einfach zu montieren ist. Die Befestigung des Gehäuses an der Leiterplatte erfolgt vorzugsweise mittels Verrasten, Verclipsen, Presspassung, Verschrauben, Verkleben oder dergleichen.

Die Anordnung der mehreren Kontaktflächen auf der Leiterplatte im Wesentlichen entlang eines Ringes entspricht der Anordnung der mehreren Sensorelemente im Gehäuse entlang der Mantelfläche des im Wesentlichen zylindrischen Detektionsabschnitts. Die Grundform des Ringes ist grundsätzlich beliebig, bevorzugt ist sie kreisförmig oder (bevorzugt regelmäßig) polygonal. Vorzugsweise sind die (z.B. geometrischen) Schwerpunkte der mehreren Kontaktflächen auf einer Linie angeordnet, welche im Wesentlichen mit der Linie übereinstimmt, auf welcher die (z.B. geometrischen) Schwerpunkte der Sensorelemente liegen. Außerdem sind die mehreren Kontaktflächen vorzugsweise entlang des gesamten Ringes angeordnet, sie können aber wahlweise auch nur entlang eines Teilabschnitts des Ringes vorgesehen sein. Form und Größe der einzelnen Kontaktflächen stimmen vorzugsweise im Wesentlichen mit jenen der Querschnitte der Sensorelemente überein, können aber auch von diesen abweichen.

In einer bevorzugten Ausgestaltung der Erfindung weisen die mehreren elektrisch leitfähigen Sensorelemente auf ihrer der Leiterplatte zugewandten Seite jeweils einen elastischen Kontaktabschnitt zum elektrisch leitfähigen Kontaktieren (wenigstens) einer der mehreren Kontaktflächen der Leiterplatte auf. Durch den elastischen Kontaktabschnitt kann ein dauerhaft sicherer elektrischer Kontakt mit einer Kontaktfläche auf der Leiterplatte gewährleistet werden und können Fertigungs- und Montagetoleranzen ausgeglichen werden. Die elastischen Kontaktabschnitte der Sensorelemente sind im zusammengebauten Zustand des Betätigungselements vorzugsweise gegen die Kontaktflächen der Leiterplatte vorgespannt.

In einer bevorzugten Ausgestaltung der Erfindung weist das Gehäuse eine dem Benutzer zugewandte (stirnseitige), elektrisch nicht-leitfähige Abdeckung zum Definieren eines weiteren berührungs- und/oder annäherungsempfindlichen Erfassungsbereiches des Betätigungselements auf, in dem eine Berührung oder Annäherung eines Benutzers erfassbar ist; ist auf der dem Benutzer abgewandten Seite der Abdeckung wenigstens ein weiteres elektrisch leitfähiges Sensorelement in dem Gehäuse angeordnet; und weist die Leiterplatte wenigstens eine weitere Kontaktfläche auf, welche mit dem wenigstens einen weiteren Sensorelement elektrisch leitend in Kontakt steht.

Bei dieser Ausgestaltung verfügt der berührungs- und/oder annäherungsempfindliche Drehknopf der Erfindung zusätzlich über wenigstens einen berührungs- und/oder annäherungsempfindlichen Tastschalter. Dies erweitert die Bedienungsmöglichkeiten für den Benutzer mit nur einem Betätigungselement. Außerdem kann die Bedienblende einfacher konzipiert werden, da weniger Betätigungselemente integriert werden müssen.

Das wenigstens eine weitere Sensorelement weist in diesem Zusammenhang vorzugsweise ein, zwei, drei oder vier weitere Sensorelemente auf. Die Anzahl der weiteren Kontaktflächen auf der Leiterplatte entspricht vorzugsweise der Anzahl dieser weiteren Sensorelemente. Die weiteren Sensorelemente stehen dabei unmittelbar oder mittelbar mit den weiteren Kontaktflächen elektrisch leitend in Kontakt. Die weiteren Sensorelemente sind sowohl zueinander als auch gegenüber den Sensorelementen elektrisch isoliert, vorzugsweise durch Trennwände des elektrisch nicht-leitfähigen Gehäuses, und die weiteren Kontaktflächen sind sowohl zueinander als auch zu den Kontaktflächen elektrisch isoliert.

Die Abdeckung ist vorzugsweise aus einem elektrisch nicht-leitfähigen Material, bevorzugt einem Kunststoffmaterial gefertigt. Die Abdeckung ist vorzugsweise als ein ein- oder mehrteiliges Spritzgussteil gefertigt. Die Abdeckung und der Detektionsabschnitt des Gehäuses sind vorzugsweise einstückig miteinander ausgebildet oder fest miteinander verbunden. Vorzugsweise ist das gesamte Gehäuse durch ein 2-Komponenten-Spritzgussverfahren gefertigt oder die Abdeckung mit dem übrigen Gehäuse verklebt.

Bei dieser Ausgestaltung weist das wenigstens eine weitere elektrisch leitfähige Sensorelement vorzugsweise eine elektrisch leitfähige Beschichtung oder Bedruckung der Abdeckung auf. Alternativ ist das wenigstens eine weitere elektrisch leitfähige Sensorelement mit Abstand zur Abdeckung im Gehäuse angeordnet.

Ferner ist bei dieser Ausgestaltung wenigstens ein elektrisch leitfähiges Kontaktelement in dem Gehäuse angeordnet, welches das wenigstens eine weitere elektrisch leitfähige Sensorelement mit der wenigstens einen weiteren Kontaktfläche der Leiterplatte elektrisch leitend verbindet.

Dieses elektrisch leitfähige Kontaktelement ist vorzugsweise elastisch in dem Gehäuse angeordnet und/oder zumindest teilweise elastisch ausgestaltet. Bevorzugt ist dieses Kontaktelement als ein Federelement aus einem elektrisch leitfähigen Material (bevorzugt Metall) und/oder als ein elektrisch leitfähiger Schaumstoffkörper ausgebildet. Durch die elastische Anordnung und/oder Ausbildung des Kontaktelements kann ein dauerhaft sicherer elektrischer Kontakt mit der weiteren Kontaktfläche auf der Leiterplatte gewährleistet werden und können Fertigungs- und Montagetoleranzen ausgeglichen werden.

In einer weiteren Ausgestaltung der Erfindung weist das Gehäuse eine dem Benutzer zugewandte, stirnseitige Abdeckung auf, welche zumindest teilweise lichtdurchlässig ausgebildet ist; und ist in dem Gehäuse wenigstens ein Anzeigeelement angeordnet.

Bei dieser Ausgestaltung verfügt der berührungs- und/oder annäherungsempfindliche Drehknopf der Erfindung zusätzlich über wenigstens ein Anzeigeelement. Dies erleichtert die Bedienung des Betätigungselements für den Benutzer, da dem Benutzer über das wenigstens eine Anzeigeelement Informationen (z.B. Einstellmöglichkeiten, aktuelle Einstellwerte, Betriebszustand, etc.) mitgeteilt werden können. Außerdem kann eine Bedieneinheit mit dieser Ausgestaltung des berührungs- und/oder annäherungsempfindlichen Drehknopfes kompakter und platzsparender ausgebildet werden, da auf zusätzliche Anzeigeelemente neben dem Drehknopf verzichtet werden kann. Außerdem kann die Bedienblende einfacher konzipiert werden, da weniger Elemente integriert werden müssen.

Unter einem Anzeigeelement soll in diesem Zusammenhang jede Art von Einrichtung verstanden werden, die geeignet ist, dem Benutzer Information optisch darzustellen. Zu den geeigneten Anzeigeelementen zählen insbesondere einfache Leuchtelemente (z.B. Leuchtioden oder Leuchtdiodengruppen), mit Leuchtelementen gekoppelte Lichtleiter, Displays (z.B. LED, LCD, etc.) und dergleichen. Das wenigstens eine Anzeigeelement weist vorzugsweise ein, zwei, drei oder vier Anzeigeelemente oder eine Einheit aus zwei oder mehr Anzeigeelementen auf.

Die Abdeckung ist vorzugsweise aus einem elektrisch nicht-leitfähigen Material, bevorzugt einem Kunststoffmaterial gefertigt. Die Abdeckung ist vorzugsweise als ein ein- oder mehrteiliges Spritzgussteil gefertigt. Die Abdeckung und der Detektionsabschnitt des Gehäuses sind vorzugsweise einstückig miteinander ausgebildet oder fest miteinander verbunden. Vorzugsweise ist das gesamte Gehäuse durch ein 2-Komponenten-Spritzgussverfahren gefertigt oder ist die Abdeckung mit dem übrigen Gehäuse verklebt.

Bei dieser Ausgestaltung weist das wenigstens eine Anzeigeelement bevorzugt wenigstens eine Befestigungsvorrichtung auf und weist das Gehäuse bevorzugt wenigstens eine Haltevorrichtung zum Eingriff mit der wenigstens einen Befestigungsvorrichtung auf. Die Verbindung zwischen Haltevorrichtung und Befestigungsvorrichtung erfolgt vorzugsweise mittels Verrasten, Verclipsen, Verkleben, Presspassung, Verschrauben oder dergleichen.

Bei dieser Ausgestaltung weist das Gehäuse bzw. seine Haltevorrichtung wenigstens eine Durchbrechung zum Durchführen einer an dem wenigstens einen Anzeigeelement angeschlossenen Verbindungsleitung auf. Vorzugsweise weist auch die Leiterplatte wenigstens eine Durchbrechung zum Durchführen dieser Verbindungsleitung auf, sodass die Verbindungsleitung auf der dem Gehäuse abgewandten Seite der Leiterplatte an dieser angeschlossen werden kann.

Die Ausgestaltungen des berührungs- und/oder annäherungsempfindlichen Betätigungselements der Erfindung mit wenigstens einem zusätzlichen berührungs- und/oder annäherungsempfindlichen Tastschalter und mit wenigstens einem zusätzlichen Anzeigeelement können vorzugsweise auch miteinander kombiniert werden. In diesem Fall ist das wenigstens eine weitere elektrisch leitfähige Sensorelement bevorzugt zumindest teilweise lichtdurchlässig ausgebildet.

In einer noch weiteren bevorzugten Ausgestaltung der Erfindung ist ferner eine Steuervorrichtung vorgesehen, welche ausgestaltet ist, um die Messsignale an den mehreren Kontaktflächen und/oder der wenigstens einen weiteren Kontaktfläche auszuwerten, und/oder das wenigstens eine Anzeigeelement in Abhängigkeit von einer Betätigung des Betätigungselements anzusteuern. Die Steuervorrichtung ist vorzugsweise auf der Leiterplatte des Betätigungselements angeordnet, kann aber auch separat und entfernt von dieser vorgesehen sein.

Die Steuervorrichtung ist vorzugsweise ausgestaltet, um die zu den einzelnen Sensorelementen bzw. weiteren Sensorelementen gehörenden Kapazitätswerte und ihre Veränderungen im Wesentlichen parallel zueinander oder sequentiell zu erfassen. Vorzugsweise ist die Steuervorrichtung ausgestaltet, um anhand der zu den Sensorelementen gehörenden Kapazitätswerten bzw. Kapazitätswertänderungen einen Drehwinkel und/oder eine Drehrichtung einer rotatorischen Bewegung eines Benutzers um das Betätigungselement herum zu erfassen.

Das oben beschriebene berührungs- und/oder annäherungsempfindliche Betätigungselement der Erfindung ist vorzugsweise in einem elektronischen Haushaltsgerät, wie beispielsweise einem Herd, einem Kochfeld, einem Mikrowellenofen, einer Spülmaschine, einer Waschmaschine, einem Wäschetrockner und dergleichen einsetzbar. Das berührungs- und/oder annäherungsempfindliche Betätigungselement der Erfindung wird dabei vorzugsweise drehfest an einer Bedienblende des Haushaltsgerätes montiert.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnung besser verständlich. Darin zeigen, zum Teil schematisch:
- Fig. 1: eine perspektivische Vorderansicht (vom Benutzer aus gesehen) einer Bedienblende eines elektronischen Haushaltsgerätes mit einem Betätigungselement gemäß der vorliegenden Erfindung;
- Fig. 2: eine perspektivische Vorderansicht (vom Benutzer aus gesehen) eines Betätigungselements gemäß einem bevorzugten Ausführungsbeispiel der vorliegenden Erfindung;
- Fig. 3: eine Seitenansicht, zum Teil im Schnitt, des in Fig. 2 dargestellten Betätigungselements;
- Fig. 4: eine Querschnittansicht des in Fig. 2 dargestellten Betätigungselements gemäß Schnittlinie IV-IV in Fig. 3;
- Fig. 5: eine perspektivische Draufsicht der Leiterplatte des Betätigungselements der Fig. 2 bis 4 gemäß einem Ausführungsbeispiel der Erfindung; und
- Fig. 6: eine Draufsicht (von der dem Benutzer abgewandten Innenseite) der Abdeckung des Betätigungselements von Fig. 2 bis 4 gemäß einem Ausführungsbeispiel der Erfindung.

Die vorliegende Erfindung wird nachfolgend anhand einer Waschmaschine beispielhaft beschrieben. Das erfindungsgemäße Betätigungselement ist aber auch in anderen elektronischen Haushaltsgeräten in entsprechender Weise einsetzbar.

Eine zum Beispiel aus Kunststoff oder Metall gefertigte Bedienblende 10 einer Waschmaschine weist eine Öffnung 12 für eine Schublade (mit einem oder mehreren Fächern für Waschmittel) auf. Zum Bedienen der Waschmaschine, d.h. insbesondere zum Eingeben eines gewünschten Waschprogramms (z.B. Kochwäsche, Buntwäsche, Schonprogramm, etc.) mit gewünschten Parametern (Waschtemperatur, Schleuderdrehzahl, etc.) durch einen Benutzer sind an der Bedienblende 10 ein oder mehrere Betätigungs- und Anzeigevorrichtungen vorgesehen.

Diese Betätigungs- und Anzeigevorrichtungen weisen erfindungsgemäß wenigstens ein berührungs- und/oder annäherungsempfindliches Betätigungselement 14 gemäß der Erfindung und optional weitere Betätigungs- und/oder Anzeigeelemente auf. Das erfindungsgemäß ausgestaltete Betätigungselement ist ausgestaltet als ein "virtueller" Drehknopf, welcher in diesem Ausführungsbeispiel in kompakter Kombination einen ersten berührungs- und/oder annäherungsempfindlichen Erfassungsbereich zum Erfassen einer rotatorischen Bewegung eines Benutzers um das Betätigungselement herum, wenigstens einen zweiten (weiteren) berührungs- und/oder annäherungsempfindlichen Erfassungsbereich zum Erfassen einer Tastbewegung eines Benutzers an dem Betätigungselement sowie wenigstens ein Anzeigeelement zum Darstellen von Informationen für den Benutzer aufweist.

Das Betätigungselement 14 ist ortsfest und insbesondere auch drehfest an der Bedienblende 10 (lösbar oder dauerhaft) befestigt. Zum Beispiel ist das Betätigungselement 14 von einer dem Benutzer abgewandten Rückseite der Bedienblende 10 her durch eine Öffnung hindurch geschoben, um in Richtung zum Benutzer aus der Bedienblende 10 heraus zu ragen (vgl. Fig. 1), und mit der Rückseite der Bedienblende 10 zum Beispiel verschraubt oder verklebt.

Der Benutzer kann das in Fig. 1 dargestellte Betätigungselement 14 zum Beispiel mit einer Hand lose oder kontaktfrei umgreifen und mit der Hand eine Drehbewegung um das Betätigungselement herum ausführen, welche von dem Betätigungselement (hinsichtlich Drehwinkel und/oder Drehrichtung) erkannt wird. Alternativ kann der Benutzer einen Finger lose oder kontaktfrei um das Betätigungselement 14 herum führen, was ebenfalls von dem Betätigungselement (hinsichtlich Drehwinkel und/oder Drehrichtung) erkannt wird. Diese Funktionalität des Betätigungselements bildet den "virtuellen" (da selbst nicht drehbaren) Drehknopf mit dem genannten ersten berührungs- und/oder annäherungsempfindlichen Erfassungsbereich. Mit Hilfe dieser Funktionalität kann der Benutzer zum Beispiel Menüpunkte einer Bedienungssteuerung auswählen, ein Waschprogramm auswählen, verschiedene Steuerungsparameter auswählen und dergleichen.

Zusätzlich kann der Benutzer die ihm zugewandte Stirnseite (zum Beispiel mit einem Finger) berühren oder sich dieser zumindest annähern. Diese Funktionalität des Betätigungselements bildet den genannten zweiten (weiteren) berührungs- und/oder annäherungsempfindlichen Erfassungsbereich. Mit Hilfe dieser Funktionalität kann der Benutzer zum Beispiel eine mittels des ersten Erfassungsbereichs getroffene Auswahl bestätigen ("OK"- oder "Enter"-Funktion). Wahlweise können auch zwei oder mehr solcher zweiten Erfassungsbereiche an der Stirnseite vorgesehen sein, um die Funktionalitäten des Betätigungselements weiter zu erweitern.

Durch die dem Benutzer zugewandte Stirnseite des Betätigungselements hindurch ist zudem wenigstens ein Anzeigeelement für den Benutzer sichtbar. Mit Hilfe dieses wenigstens einen Anzeigeelements können dem Benutzer verschiedene Informationen dargestellt werden, zum Beispiel die Menüführung der Bedienungssteuerung, die Auswahlmöglichkeiten an Waschprogrammen, die Auswahlmöglichkeiten der verschiedenen Steuerungsparameter, die aktuellen Einstellungen, der aktuelle Betriebszustand der Waschmaschine und dergleichen. Entsprechend den darzustellenden Informationen weist das wenigstens eine Anzeigeelement einfache Farbanzeigen (z.B. mittels einfacher Leuchtdioden oder mit Leuchtdioden gekoppelter Lichtleiter) und/oder Displays (z.B. LED- oder LCD-Displays) auf.

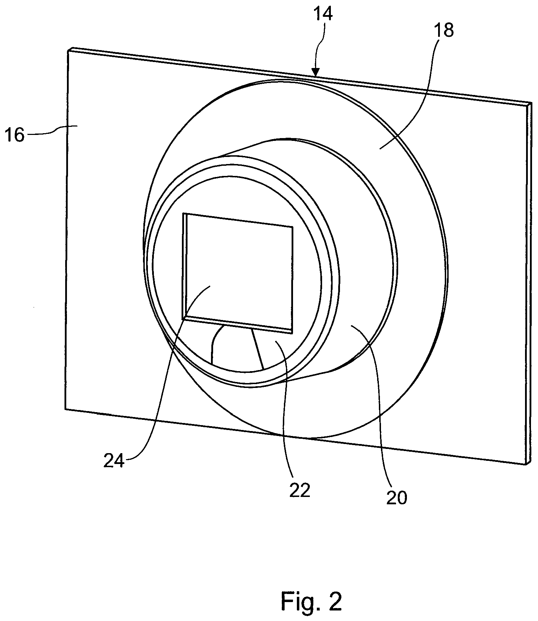

Der Aufbau und die Funktionsweise eines solchen "virtuellen" Drehknopfes werden nachfolgend anhand eines bevorzugten Ausführungsbeispiels Bezug nehmend auf Fig. 2 bis 6 näher erläutert.

Wie in Fig. 2 veranschaulicht, weist das Betätigungselement 14 eine Leiterplatte 16 auf, welche die Sensorschaltungen und optional auch die Auswerteelektronik und die Steuervorrichtung für das Betätigungselement trägt. Das Betätigungselement 14 ist über einen flanschförmigen Befestigungsabschnitt 18 drehfest mit der Leiterplatte 16 verbunden. Dieser Befestigungsabschnitt 18 dient gleichzeitig der drehfesten Befestigung des Betätigungselements 14 an der Bedienblende 10.

In Fig. 2 sind zudem der im Wesentlichen zylindrische Detektionsabschnitt 20, der den ersten berührungs- und/oder annäherungsempfindlichen Erfassungsbereich definiert, die stirnseitige Abdeckung 22, die den zweiten berührungs- und/oder annäherungsempfindlichen Erfassungsbereich definiert, und ein Display als Anzeigeelement 24 zu erkennen.

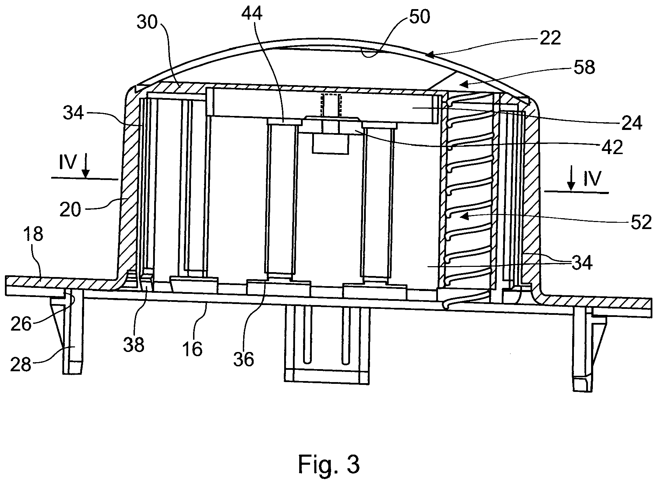

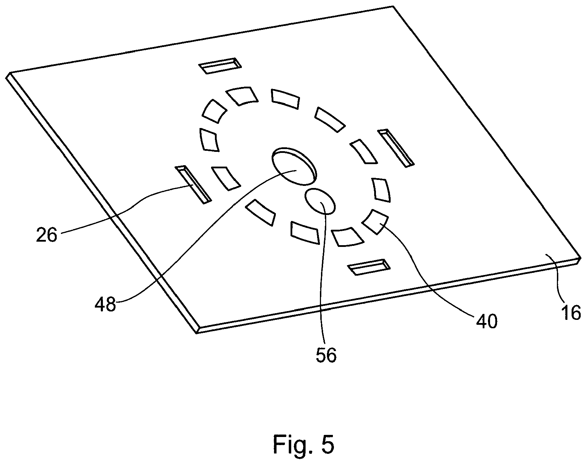

Wie in Fig. 3 und 5 dargestellt, weist die Leiterplatte 16 mehrere schlitzförmige Durchbrechungen 26 auf und weist der Befestigungsabschnitt 18 mehrere Rastelemente 28 auf. Die Rastelemente 28 an dem Befestigungsabschnitt 18 sind derart angeordnet und ausgebildet, dass sie durch die Durchbrechungen 26 in der Leiterplatte 16 hindurch gesteckt werden können und dann verrasten, um den Befestigungsabschnitt 18 fest mit der Leiterplatte 16 zu verbinden. Die Durchbrechungen 26 und Rastelemente 28 gewährleisten zudem eine korrekte Ausrichtung der Leiterplatte 16 relativ zu den übrigen Komponenten des Betätigungselements 14. In dem gezeigten Ausführungsbeispiel sind vier Durchbrechungen 26 und vier Rastelemente 28 vorhanden, es können aber ebenso weniger oder mehr als vier dieser Verbindungskomponenten vorgesehen sein.

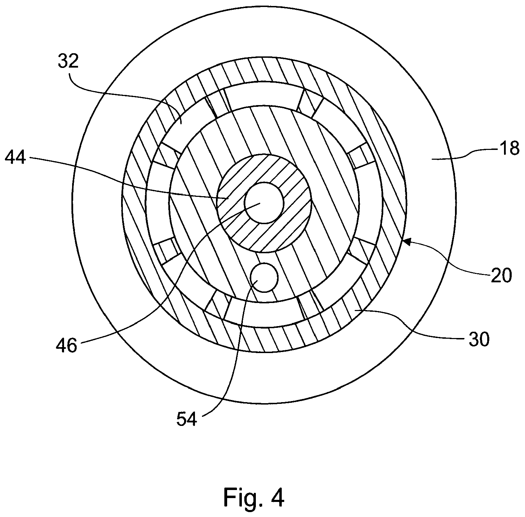

Wie in Fig. 3 und 4 dargestellt, ist der Befestigungsabschnitt 18 Teil eines Gehäuses 30 aus einem elektrisch nicht-leitfähigen Kunststoffmaterial. An den flanschförmigen Befestigungsabschnitt 18 schließt sich insbesondere der im Wesentlichen zylindrische Detektionsabschnitt 20 an. Das Gehäuse 30 mit den Abschnitten 18, 20 ist beispielsweise einstückig als Spritzgussteil gefertigt.

Die Grundform des im Wesentlichen zylindrischen Detektionsbereichs 20 des Gehäuses 30 ist in diesem Ausführungsbeispiel im Wesentlichen kreisförmig (vgl. Fig. 4). Alternativ sind auch andere Grundformen (z.B. polygonal, oval, etc.) möglich. Die Grundform des flanschförmigen Befestigungsabschnitts 18 ist in diesem Ausführungsbeispiel ebenfalls im Wesentlichen kreisförmig und im Wesentlichen koaxial zum Detektionsabschnitt 20 ausgestaltet. In anderen Ausführungsbeispielen kann die Grundform des Befestigungsabschnitt 18 aber auch unabhängig vom Detektionsabschnitt 20 ausgestaltet sein.

Der Detektionsabschnitt 20 muss darüber hinaus nicht notwendigerweise eine gerade Zylinderform besitzen. Wie in Fig. 3 angedeutet, kann sich der Detektionsabschnitt 20 in Richtung vom Befestigungsabschnitt 18 weg auch konisch verjüngen. Alternativ sind auch konische Erweiterungen des Detektionsabschnitts 20 möglich. Ferner kann die Mantelfläche des Detektionsabschnitts 20 in Richtung weg vom Befestigungsabschnitt 18 (Unten/Oben-Richtung in Fig. 3) im Wesentlichen geradlinig verlaufen, wie im Ausführungsbeispiel von Fig. 3, oder auch ein- oder mehrfach konvex und/oder konkav gekrümmt ausgebildet sein. Es existieren dabei große Freiheitsgrade auch im Hinblick auf das Design des Betätigungselements 14.

Im Bereich des Detektionsabschnitts 20 sind im Gehäuse 30 entlang der Mantelfläche des Detektionsabschnitts 20, d.h. im Wesentlichen ringförmig, mehrere Ausnehmungen oder Taschen 32 ausgebildet (vgl. Fig. 4). In diesen Ausnehmungen 32 ist jeweils ein elektrisch leitfähiges Sensorelement 34 angeordnet. Die Sensorelemente 34 sind beispielsweise plattenförmige Elemente aus Metall. Die mehreren Sensorelemente 34 sind somit ebenfalls entlang der Mantelfläche des Detektionsabschnitts 20 und zueinander beabstandet (und so elektrisch voneinander isoliert) in dem Gehäuse 30 angeordnet.

Im Fall eines im Wesentlichen kreiszylindrischen Detektionsabschnitts 20 sind die mehreren Sensorelemente 34 im Wesentlichen entlang eines Kreisringes angeordnet. In anderen Ausführungsbeispielen mit anders ausgestalteten Detektionsabschnitten 20 wird die Anordnung der Sensorelemente 34 entsprechend angepasst.

Im vorliegenden Ausführungsbeispiel sind zudem die Ausnehmungen 32 und die Sensorelemente 34 entlang der Mantelfläche des Detektionsabschnitts 20 gekrümmt ausgebildet. In anderen Ausführungsbeispielen können auch im Wesentlichen plane Sensorelemente 34 verwendet werden. In solchen Fällen sind dann die zum Beispiel geometrischen Schwerpunkte der Querschnittsformen auf einem Ring entlang der Mantelfläche des Detektionsabschnitts angeordnet.

Ferner sind im vorliegenden Ausführungsbeispiel (Fig. 4) beispielhaft acht Sensorelemente 34 vollumfänglich entlang der gesamten Mantelfläche des Detektionsabschnitts 20 vorgesehen. In anderen Ausführungsbeispielen können auch andere Anzahlen (z.B. vier, sechs, zwölf, sechzehn, etc.) von Sensorelementen 34 vorgesehen sein. Auch können die Sensorelemente 34 in anderen Ausführungsbeispielen nur entlang eines Teils (z.B. etwa 300°, 240°, 210°, 180°, etc.) der Mantelfläche des Detektionsabschnitts 20 angeordnet sein. Im letztgenannten Fall können die Ausnehmungen 32 entweder ebenfalls nur entlang eines Teils der Mantelfläche ausgebildet sein oder entlang der gesamten Mantelfläche ausgebildet, aber nur teilweise besetzt sein.

Die elektrisch leitfähigen Sensorelemente 34 stehen jeweils mit einer Kontaktfläche 40 auf der Leiterplatte 16 elektrisch leitend in Kontakt. Wie in Fig. 5 dargestellt, sind die Kontaktflächen 40 auf der Leiterplatte 16 im Wesentlichen entlang eines Kreisringes angeordnet. Anordnung, Gestalt und Größe der Kontaktflächen 40 sind dabei auf die Sensorelemente 34 abgestimmt und können in anderen Ausführungsbeispielen dementsprechend auch anders ausgestaltet sein.

Im vorliegenden Ausführungsbeispiel sind die Kontaktflächen 40 auf der dem Gehäuse 30 zugewandten Seite der Leiterplatte 16 vorgesehen und die Sensorelemente 34 kontaktieren diese Kontaktflächen 40 direkt.

Wie in Fig. 3 angedeutet, sind die Sensorelemente 34 vorzugsweise jeweils mit wenigstens einem Rastabschnitt 36 versehen. Mit diesen Rastabschnitten 36 können die Sensorelemente 34 in den Ausnehmungen 32 des Gehäuses 30 einrasten und darin gehalten werden. Auf diese Weise kann der Zusammenbau des Betätigungselements 14 vereinfacht werden.

Zudem sind die Sensorelemente 34 vorzugsweise jeweils an ihrem der Leiterplatte 16 zugewandten Endbereich mit einem elastischen Kontaktabschnitt 38 ausgebildet. Zum Beispiel sind die Sensorelemente 34 jeweils an ihrem der Leiterplatte 16 zugewandten Ende leicht gekrümmt und damit im zusammengebauten Zustand des Betätigungselements 14 gegen die Leiterplatte 16 bzw. die Kontaktflächen 40 auf der Leiterplatte 16 vorgespannt. Auf diese Weise können zum Beispiel Herstellungs- und Montagetoleranzen ausgeglichen werden und dauerhaft ein sicherer elektrischer Kontakt zwischen den Sensorelementen 34 und den zugehörigen Kontaktflächen 40 gewährleistet werden.

Die Rastabschnitte 36 und die elastischen Kontaktabschnitte 38 sind vorzugsweise einstückig an den Sensorelementen 34 ausgebildet.

Auf der dem Benutzer zugewandten Stirnseite des Gehäuses 30 weist dieses zudem eine Abdeckung 22 auf. Diese Abdeckung 22 ist ebenfalls aus einem elektrisch nicht-leitfähigen Kunststoffmaterial gefertigt. Zudem ist diese Abdeckung 22 zumindest teilweise lichtdurchlässig bzw. transparent ausgebildet. Die Abdeckung 22 ist fest mit dem Detektionsabschnitt 20 verbunden (z.B. verklebt) oder integral mit dem übrigen Gehäuse 30 ausgebildet (z.B. mittels 2-Komponenten-Spritzgießen). Alternativ kann die Abdeckung 22 auf den Detektionsabschnitt 20 geclipst sein.

Die Abdeckung 22 ist in diesem Ausführungsbeispiel haubenförmig ausgebildet, d.h. in Richtung zum Benutzer hin konvex gekrümmt. In anderen Ausführungsbeispielen kann die Abdeckung auch konkav gekrümmt sein, mehrfach gekrümmt sein, im Wesentlichen plan ausgebildet sein, etc.

Hinter der Abdeckung 22, d.h. auf der dem Benutzer abgewandten Innenseite der Abdeckung, ist in dem Gehäuse 30 ein Anzeigeelement 24 in Form eines Displays (z.B. LED- oder LCD-Technik) angeordnet.

Wie in Fig. 3 angedeutet, weist dieses Display 24 eine Befestigungsvorrichtung 42 auf, mit der es an einer Haltevorrichtung 44 im Gehäuse 44 zum Beispiel durch Verrasten montiert werden kann. Das Gehäuse 30 bzw. die Haltevorrichtung 44 weist zudem eine im Wesentlichen mittige Durchbrechung 46 auf (vgl. Fig. 4), durch welche eine Verbindungsleitung (nicht dargestellt) zum Display 24 geführt werden kann. Fluchtend zu dieser Durchbrechung 46 weist auch die Leiterplatte 16 eine Durchbrechung 48 auf (vgl. Fig. 5), sodass die Verbindungsleitung zu der dem Gehäuse 30 abgewandten Seite der Leiterplatte 16 geführt und dort angeschlossen werden kann.

Neben dem Display 24 können optional weitere Anzeigeelemente zum Beispiel in Form von Lichtleitern, die mit Leuchtdioden(gruppen) auf der Leiterplatte 16 gekoppelt sind, hinter der transparenten Abdeckung 22 vorgesehen sein.

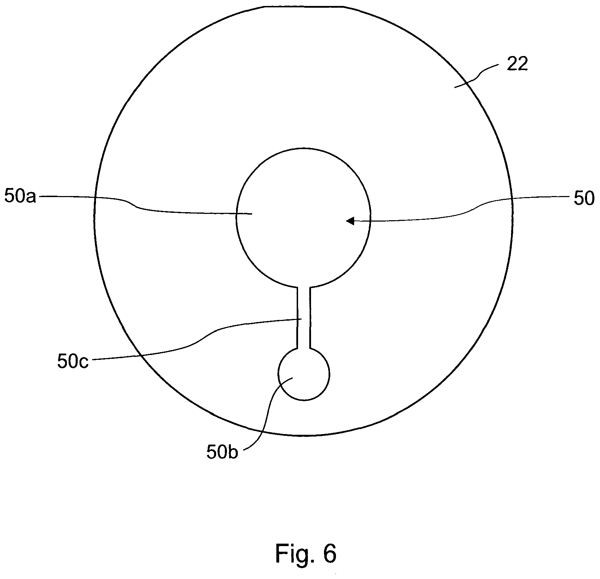

Wie in Fig. 6 dargestellt, ist auf der dem Benutzer abgewandten Innenseite der Abdeckung 22 ein weiteres elektrisch-leitfähiges Sensorelement 50 vorgesehen. Dieses weitere Sensorelement 50 ist beispielsweise als eine Beschichtung oder ein Aufdruck auf der Abdeckung 22 aufgebracht. Das weitere Sensorelement 50 ist dabei lichtdurchlässig ausgebildet (z.B. in Form eines Rasterdrucks), sodass das Display 24 für den Benutzer durch die Abdeckung 22 hindurch erkennbar bleibt. In anderen Ausführungsbeispielen kann auch ein plattenförmiges weiteres Sensorelement 50 mit oder ohne Abstand zur Abdeckung 22 verwendet werden.

Das weitere Sensorelement 50 bildet den oben genannten zweiten kapazitiven Erfassungsbereich des Betätigungselements 14. Es hat eine im Wesentlichen mittige, zum Beispiel kreisförmige oder quadratische Sensorfläche 50a, eine außermittige Kontaktfläche 50b und eine Verbindungsfläche 50c zwischen Sensorfläche 50a und Kontaktfläche 50b, wie in Fig. 6 beispielhaft veranschaulicht.

Die Kontaktfläche 50b des weiteren Sensorelements 50 ist über ein elektrisch leitfähiges Kontaktelement 52 mit einer weiteren Kontaktfläche 56 auf der Leiterplatte 16 elektrisch leitend verbunden (vgl. Fig. 3 und 5). Dieses Kontaktelement 52 ist beispielsweise als Metallfeder ausgebildet, um dauerhaft einen sicheren elektrisch leitenden Kontakt zur weiteren Kontaktfläche 56 zu gewährleisten. Das Kontaktelement 52 ist außerdem in einer weiteren Ausnehmung oder Tasche 54 in dem Gehäuse 30 angeordnet und so geführt.

Zur dauerhaft sicheren elektrisch leitenden Kontaktierung zwischen der Kontaktfläche 50b des weiteren Sensorelements 50 und dem Kontaktelement 52 ist zudem ein weiteres elektrisch leitfähiges, elastisches Kontaktelement 58 vorgesehen. Dieses weitere Kontaktelement 58 sitzt zwischen der Kontaktfläche 50b des weiteren Sensorelements 50 und dem Kontaktelement 52 im Gehäuse 30 und ist beispielsweise als elektrisch leitfähiger Schaumstoffkörper ausgebildet. In anderen Ausführungsbeispielen können das Kontaktelement 52 und das weitere Kontaktelement 58 auch integral miteinander bzw. als ein Bauteil ausgebildet sein.

Das Betätigungselement 14 weist zudem eine Steuervorrichtung auf oder ist mit einer solchen verbunden. Diese Steuervorrichtung ist auf der Leiterplatte 16 des Betätigungselements 14 oder entfernt von dieser angeordnet.

Die Steuervorrichtung enthält vorzugsweise einen Mikrocontroller und ist derart ausgestaltet, dass sie mit den (weiteren) Kontaktflächen 40, 56 der Leiterplatte 16 verbunden ist, um so die Kapazitätswerte bzw. Kapazitätswertänderungen an den (weiteren) Sensorelementen 34, 50 zu erfassen. Das Abgreifen der Messsignal erfolgt dabei im Wesentlichen parallel oder sequentiell.

Dabei ist die Steuervorrichtung beispielsweise derart ausgestaltet, dass sie einen Drehwinkel und/oder eine Drehrichtung einer rotatorischen Bewegung eines Benutzers um den Detektionsabschnitt 20 des Betätigungselements 14 herum erfassen kann.

Das Funktionsprinzip eines berührungs- und/oder annäherungsempfindlichen kapazitiven Tastschalters ist dem Fachmann grundsätzlich bekannt. Der "virtuelle" Drehknopf 14 der Erfindung setzt sich wie oben beschrieben aus mehreren solchen berührungs- und/oder annäherungsempfindlichen Tastschaltern zusammen, welche entlang der Mantelfläche des im Wesentlichen zylindrischen Detektionsabschnitts ausgebildet sind. Durch eine Erfassung und Auswertung der zeitlichen Veränderungen der Kapazitätswerte von mehreren, vorzugsweise von allen diesen Tastschaltern lassen sich sowohl ein Maß als auch eine Richtung einer Bewegung über mehrere Tastschalter hinweg ermitteln, im vorliegenden Fall somit Drehwinkel und/oder Drehrichtung der rotatorischen Bewegung des Benutzers.

Die Steuervorrichtung weist zu diesem Zweck beispielsweise einen Mikrocontroller bzw. Prozessor und einen Speicher bzw. Zustandsregister auf.

Ferner ist die Steuervorrichtung über die Verbindungsleitung auch mit dem Display 24 verbunden. Die Steuervorrichtung ist dabei ausgestaltet, das Display 24 in Abhängigkeit von einer Betätigung des Betätigungselements 14 in seinen zwei berührungs- und/oder annäherungsempfindlichen Erfassungsbereichen anzusteuern. Beispielsweise werden die im Display 24 angezeigten Informationen nach einer Betätigung des ersten oder zweiten Erfassungsbereichs des Betätigungselements 14 entsprechend verändert.

### BEZUGSZIFFERNLISTE

- 10: Bedienblende
- 12: Öffnung für Schublade
- 14: Betätigungselement / Drehknopf
- 16: Leiterplatte
- 18: Befestigungsabschnitt / Flansch
- 20: Detektionsabschnitt
- 22: (stirnseitige) Abdeckung
- 24: Anzeigeelement / Display
- 26: Durchbrechung in 16
- 28: Rastelement an 18
- 30: Gehäuse
- 32: Ausnehmung für 34
- 34: elektrisch leitfähiges Sensorelement
- 36: Rastabschnitt von 34
- 38: (elastischer) Kontaktabschnitt von 34
- 40: Kontaktfläche auf 16
- 42: Befestigungselement an 24
- 44: Haltevorrichtung / Displayhalterung
- 46: Durchbrechung in 44
- 48: Durchbrechung in 16
- 50: weiteres elektrisch leitfähiges Sensorelement
- 50a: Sensorfläche
- 50b: Kontaktfläche
- 50c: Verbindungsfläche
- 52: elektrisch leitfähiges Kontaktelement
- 54: Ausnehmung für 52
- 56: weitere Kontaktfläche auf 16
- 58: weiteres elektrisch leitfähiges (elastisches) Kontaktelement

## Patentansprüche

1. Berührungs- und/oder annäherungsempfindliches Betätigungselement (14), insbesondere für ein elektronisches Haushaltsgerät, aufweisend:
ein elektrisch nicht-leitfähiges Gehäuse (30), welches einen im Wesentlichen zylindrischen Detektionsabschnitt (20), der einen berührungs- und/oder annäherungsempfindlichen Erfassungsbereich des Betätigungselements definiert, an dem eine rotatorische Bewegung eines Benutzers um das Betätigungselement erfassbar ist, aufweist;
mehrere elektrisch leitfähige Sensorelemente (34), welche entlang einer Mantelfläche des Detektionsabschnitts (20) zueinander beabstandet in dem Gehäuse (30) angeordnet sind; und
eine Leiterplatte (16), welche mehrere Kontaktflächen (40) aufweist, welche jeweils mit einem der mehreren Sensorelemente (34) elektrisch leitend in Kontakt stehen, wobei
das Gehäuse (30) ferner einen Befestigungsabschnitt (18) zur orts- und drehfesten Montage des Betätigungselements (14) an einer Bedienblende (10) aufweist;
die Leiterplatte (16) auf einer dem Benutzer abgewandten Seite unmittelbar angrenzend an das Gehäuse (30) angeordnet ist; und
das Gehäuse (30) über den Befestigungsabschnitt (18) drehfest an der Leiterplatte (16) befestigt ist und die mehreren Kontaktflächen (40) im Wesentlichen entlang eines Ringes auf der Leiterplatte (16) angeordnet sind und jeweils eines der mehreren Sensorelemente (34) im Gehäuse (30) elektrisch leitend kontaktieren.

2. Betätigungselement nach Anspruch 1,
**dadurch gekennzeichnet, dass**
die mehreren elektrisch leitfähigen Sensorelemente (34) auf ihrer der Leiterplatte (16) zugewandten Seite jeweils einen elastischen Kontaktabschnitt (38) zum elektrisch leitfähigen Kontaktieren einer der mehreren Kontaktflächen (40) der Leiterplatte (16) aufweisen.

3. Betätigungselement nach einem der vorhergehenden Ansprüche,
**dadurch gekennzeichnet, dass**
das Gehäuse (30) eine dem Benutzer zugewandte, stirnseitige Abdeckung (22) aufweist, welche zumindest teilweise lichtdurchlässig ausgebildet ist; und
in dem Gehäuse (30) wenigstens ein Anzeigeelement (24) angeordnet ist.

4. Betätigungselement nach Anspruch 3,
**dadurch gekennzeichnet, dass**
das wenigstens eine Anzeigeelement (24) wenigstens eine Befestigungsvorrichtung (42) aufweist und das Gehäuse (30) wenigstens eine Haltevorrichtung (44) zum Eingriff mit der wenigstens einen Befestigungsvorrichtung (42) aufweist.

5. Betätigungselement nach Anspruch 3 oder 4,
**dadurch gekennzeichnet, dass**
das Gehäuse (30) und/oder seine Haltevorrichtung (44) wenigstens eine Durchbrechung (46) zum Durchführen einer an dem wenigstens einen Anzeigeelement (24) angeschlossenen Verbindungsleitung aufweist.

6. Betätigungselement nach einem der vorhergehenden Ansprüche,
**dadurch gekennzeichnet, dass**
das Gehäuse (30) eine dem Benutzer zugewandte, elektrisch nicht-leitfähige Abdeckung (22) zum Definieren eines weiteren berührungs- und/oder annäherungsempfindlichen Erfassungsbereiches des Betätigungselements (14), in dem eine Berührung oder Annäherung eines Benutzers erfassbar ist, aufweist;
auf der dem Benutzer abgewandten Seite der Abdeckung (22) wenigstens ein weiteres elektrisch leitfähiges Sensorelement (50) in dem Gehäuse (30) angeordnet ist; und
die Leiterplatte (16) wenigstens eine weitere Kontaktfläche (56) aufweist, welche mit dem wenigstens einen weiteren Sensorelement (50) elektrisch leitend in Kontakt steht.

7. Betätigungselement nach Anspruch 6,
**dadurch gekennzeichnet, dass**
das wenigstens eine weitere elektrisch leitfähige Sensorelement (50) eine elektrisch leitfähige Beschichtung oder Bedruckung der Abdeckung (22) aufweist.

8. Betätigungselement nach Anspruch 6 oder 7,
**dadurch gekennzeichnet, dass**
wenigstens ein elektrisch leitfähiges Kontaktelement (52) in dem Gehäuse (30) angeordnet ist, welches das wenigstens eine weitere elektrisch leitfähige Sensorelement (50) mit der wenigstens einen weiteren Kontaktfläche (56) der Leiterplatte (16) elektrisch leitend verbindet.

9. Betätigungselement nach Anspruch 8,
**dadurch gekennzeichnet, dass**
das wenigstens eine elektrisch leitfähige Kontaktelement (52) elastisch in dem Gehäuse (30) angeordnet und/oder zumindest teilweise elastisch ausgestaltet ist.

10. Betätigungselement nach einem der Ansprüche 6 bis 9,
**dadurch gekennzeichnet, dass**
das wenigstens eine weitere elektrisch leitfähige Sensorelement (50) zumindest teilweise lichtdurchlässig ausgebildet ist.

11. Betätigungselement nach einem der vorhergehenden Ansprüche,
**dadurch gekennzeichnet, dass**
eine Steuervorrichtung vorgesehen ist, welche ausgestaltet ist, um die Messsignale an den mehreren Kontaktflächen (40) und/oder der wenigstens einen weiteren Kontaktfläche (56) auszuwerten, und/oder das wenigstens eine Anzeigeelement (24) in Abhängigkeit von einer Betätigung des Betätigungselements (14) anzusteuern.

12. Elektronisches Haushaltsgerät mit einer Bedienblende (10) und wenigstens einem berührungs- und/oder annäherungsempfindlichen Betätigungselement (14) nach einem der vorhergehenden Ansprüche, das über den Befestigungsabschnitt (18) des Gehäuses (30) an der Bedienblende (10) montiert ist.

13. Haushaltsgerät nach Anspruch 12,
**dadurch gekennzeichnet, dass**
die Leiterplatte (16) des Betätigungselements (14) auf einer dem Benutzer abgewandten Seite der Bedienblende (10) positioniert ist.

## Claims

1. Touch- and/or proximity-sensitive actuation element (14), in particular for an electronic domestic appliance, having:
an electrically non-conductive housing (30), which has a substantially cylindrical detection portion (20), which defines a touch- and/or proximity-sensitive detection region of the actuation element, at which a rotary movement of a user around the actuation element can be detected;
a plurality of electrically conductive sensor elements (34), which are arranged in the housing (30) spaced apart from one another along a lateral surface of the detection portion (20); and
a printed circuit board (16), which has a plurality of contact faces (40), which are each electrically conductively in contact with one of the plurality of sensor elements (34),
wherein the housing (30) furthermore has a fastening portion (18) for the stationary and non-rotational mounting of the actuation element (14) on an operator control panel (10);
the printed circuit board (16) is arranged directly bordering the housing (30) on a side facing away from the user; and
the housing (30) is fastened to the printed circuit board (16) in a non-rotational manner by way of the fastening portion (18), and the plurality of contact faces (40) are arranged on the printed circuit board (16) substantially along a ring and each electrically conductively contact one of the plurality of sensor elements (34) in the housing (30).

2. Actuation element according to Claim 1,
**characterized in that**
the plurality of electrically conductive sensor elements (34) each have, on their side facing toward the printed circuit board (16), a resilient contact portion (38) for electrically conductively contacting one of the plurality of contact faces (40) of the printed circuit board (16).

3. Actuation element according to one of the preceding claims,
**characterized in that**
the housing (30) has an end-face cover (22) facing toward the user, which cover is at least partially transmissive to light; and at least one indicating element (24) is arranged in the housing (30).

4. Actuation element according to Claim 3,
**characterized in that**
the at least one indicating element (24) has at least one fastening device (42) and the housing (30) has at least one retaining device (44) for engagement with the at least one fastening device (42) .

5. Actuation element according to Claim 3 or 4,
**characterized in that**
the housing (30) and/or retaining device (44) thereof has at least one aperture (46) for guiding through a connection line connected to the at least one indicating element (24).

6. Actuation element according to one of the preceding claims,
**characterized in that**
the housing (30) has an electrically non-conductive cover (22) facing toward the user for defining a further touch- and/or proximity-sensitive detection region of the actuation element (14), in which a touch or approach of a user can be detected;
at least one further electrically conductive sensor element (50) is arranged in the housing (30) on the side of the cover (22) facing away from the user; and
the printed circuit board (16) has at least one further contact face (56), which is electrically conductively in contact with the at least one further sensor element (50).

7. Actuation element according to Claim 6,
**characterized in that**
the at least one further electrically conductive sensor element (50) has an electrically conductive coating or printing of the cover (22).

8. Actuation element according to Claim 6 or 7,
**characterized in that**
at least one electrically conductive contact element (52) is arranged in the housing (30) and electrically conductively connects the at least one further electrically conductive sensor element (50) to the at least one further contact face (56) of the printed circuit board (16).

9. Actuation element according to Claim 8,
**characterized in that**
the at least one electrically conductive contact element (52) is arranged resiliently in the housing (30) and/or is formed at least partially resiliently.

10. Actuation element according to one of Claims 6 to 9,
**characterized in that**
the at least one further electrically conductive sensor element (50) is at least partially transmissive to light.

11. Actuation element according to one of the preceding claims,
**characterized in that**
a control device is provided, which is designed to evaluate the measurement signals at the plurality of contact faces (40) and/or the at least one further contact face (56), and/or to control the at least one indicating element (24) depending on an actuation of the actuation element (14).

12. Electronic domestic appliance comprising an operator control panel (10) and at least one touch- and/or proximity-sensitive actuation element (14) according to one of the preceding claims, which is mounted on the operator control panel (10) by way of the fastening portion (18) of the housing (30).

13. Domestic appliance according to Claim 12,
**characterized in that**
the printed circuit board (16) of the actuation element (14) is positioned on a side of the operator control panel (10) facing away from the user.

## Revendications

1. Élément d'actionnement (14) sensible au toucher et/ou à l'approche, notamment pour un appareil ménager électronique, comprenant :
un boîtier (30) électriquement non conducteur, lequel possède une portion de détection (20) sensiblement cylindrique qui définit une zone de détection sensible au toucher et/ou à l'approche de l'élément d'actionnement et au niveau de laquelle peut être détecté un mouvement de rotation d'un utilisateur autour de l'élément d'actionnement ;
plusieurs éléments de détection (34) électriquement conducteurs, qui sont disposés dans le boîtier (30) espacés les uns des autres le long d'une enveloppe de la portion de détection (20) ; et
un circuit imprimé (16), lequel possède plusieurs surfaces de contact (40) qui se trouvent respectivement en contact électriquement conducteur avec l'un des plusieurs éléments de détection (34),
le boîtier (30) possédant en outre une portion de fixation (18) servant au montage en position fixe ou solidaire en rotation de l'élément d'actionnement (14) sur un écran d'opération (10) ;
le circuit imprimé (16) étant disposé sur un côté à l'opposé de l'utilisateur directement adjacent au boîtier (30) ; et
le boîtier (30) étant fixé solidaire en rotation au circuit imprimé (16) par le biais de la portion de fixation (18) et les plusieurs surfaces de contact (40) étant disposée sur le circuit imprimé (16) sensiblement le long d'un anneau et entrant respectivement en contact électriquement conducteur avec l'un des plusieurs éléments de détection (34).

2. Élément d'actionnement selon la revendication 1, **caractérisé en ce que** les plusieurs éléments de détection (34) électriquement conducteurs possèdent respectivement, sur leur côté faisant face au circuit imprimé (16), une portion de contact (38) élastique destinée à entrer en contact électriquement conducteur avec l'une des plusieurs surfaces de contact (40) du circuit imprimé (16) .

3. Élément d'actionnement selon l'une des revendications précédentes, **caractérisé en ce que** le boîtier (30) possède un cache (22) côté frontal qui fait face à l'utilisateur, lequel est configuré au moins partiellement transparent ; et au moins un élément d'affichage (24) est disposé dans le boîtier (30).

4. Élément d'actionnement selon la revendication 3, **caractérisé en ce que** l'au moins un élément d'affichage (24) possède au moins un dispositif de fixation (42) et le boîtier (30) possède au moins un dispositif de maintien (44) destiné à venir en prise avec l'au moins un dispositif de fixation (42).

5. Élément d'actionnement selon la revendication 3 ou 4, **caractérisé en ce que** le boîtier (30) et/ou son dispositif de maintien (44) possède au moins une percée (46) servant au passage d'une ligne de liaison raccordée à l'au moins un élément d'affichage (24).

6. Élément d'actionnement selon l'une des revendications précédentes, **caractérisé en ce que** le boîtier (30) possède un cache (22) électriquement non conducteur qui fait face à l'utilisateur destiné à définir une zone de détection supplémentaire sensible au toucher et/ou à l'approche de l'élément d'actionnement (14), dans laquelle peut être détecté un toucher ou une approche d'un utilisateur ;
au moins un élément de détection supplémentaire (50) électriquement conducteur est disposé dans le boîtier (30) sur le côté du cache (22) à l'opposé de l'utilisateur ; et
le circuit imprimé (16) possède au moins une surface de contact supplémentaire (56) qui se trouve en contact électriquement conducteur avec l'au moins un élément de détection supplémentaire (50).

7. Élément d'actionnement selon la revendication 6, **caractérisé en ce que** l'au moins un élément de détection supplémentaire (50) électriquement conducteur possède un revêtement ou une impression électriquement conducteur du cache (22).

8. Élément d'actionnement selon la revendication 6 ou 7, **caractérisé en ce qu'**au moins un élément de contact (52) électriquement conducteur est disposé dans le boîtier (30), lequel relie de manière électriquement conductrice l'au moins un élément de détection supplémentaire (50) électriquement conducteur à l'au moins une surface de contact supplémentaire (56) du circuit imprimé (16).

9. Élément d'actionnement selon la revendication 8, **caractérisé en ce que** l'au moins un élément de contact (52) électriquement conducteur est disposé de manière élastique dans le boîtier (30) et/ou est de configuration au moins partiellement élastique.

10. Élément d'actionnement selon au moins l'une des revendications 6 à 9, **caractérisé en ce que** l'au moins un élément de détection supplémentaire (50) électriquement conducteur est de configuration au moins partiellement transparente.

11. Élément d'actionnement selon au moins l'une des revendications précédentes, **caractérisé en ce qu'**un dispositif de commande est présent, lequel est configuré pour interpréter les signaux de mesure au niveau des plusieurs surfaces de contact (40) et/ou de l'au moins une surface de contact supplémentaire (56), et/ou commander l'au moins un élément d'affichage (24) en fonction d'un actionnement de l'élément d'actionnement (14) .

12. Appareil ménager électronique comprenant un écran d'opération (10) et au moins un élément d'actionnement (14) sensible au toucher et/ou à l'approche selon au moins l'une des revendications précédentes, lequel est monté sur l'écran d'opération (10) par le biais de la portion de fixation (18) du boîtier (30).

13. Appareil ménager selon la revendication 12, **caractérisé en ce que** le circuit imprimé (16) de l'élément d'actionnement (14) est positionné sur un côté de l'écran d'opération (10) à l'opposé de l'utilisateur.
